Europäisches Patentamt

European Patent Office

Office européen des brevets

(11) Veröffentlichungsnummer: **0 214 376**
**A2**

(12) **EUROPÄISCHE PATENTANMELDUNG**

(21) Anmeldenummer: **86107972.1**

(22) Anmeldetag: **11.06.86**

(51) Int. Cl.⁴: **H03G 3/20** , **H03G 1/00**

(30) Priorität: **02.09.85 DE 3531274**

(43) Veröffentlichungstag der Anmeldung:
**18.03.87 Patentblatt 87/12**

(84) Benannte Vertragsstaaten:
**AT DE GB**

(71) Anmelder: **ANT Nachrichtentechnik GmbH**
**Gerberstrasse 33**
**D-7150 Backnang(DE)**

(72) Erfinder: **Wermuth, Jürgen, Ing. grad.**
**Drosselweg 1**
**D-3150 Peine(DE)**

(74) Vertreter: **Wiechmann, Manfred, Dipl.-Ing.**
**ANT Nachrichtentechnik GmbH**
**Gerberstrasse 33**
**D-7150 Backnang(DE)**

(54) **Schaltungsanordnung für eine rauscharme Tonfrequenzquelle.**

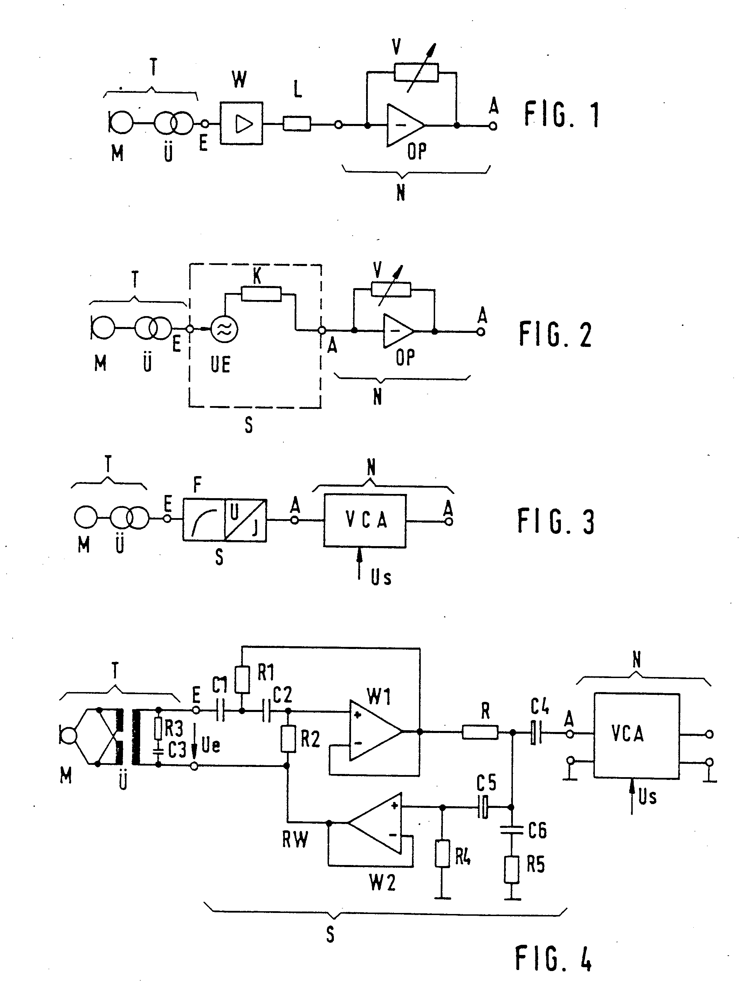

㊼ Eine Schaltungsanordnung S dient dazu, einen bevorzugt steuerbaren Null-Ohm-Verstärker N an eine rauscharme Tonfrequenzquelle T anzuschließen, die bevorzugt ein Mikrofon M enthält. Damit der Null-Ohm-Verstärker N ein bereits ausreichend hoch über dem Rauschen liegendes Nutzsignal erhält, ist die Schaltungsanordnung eingangs- und ausgangsseitig hochohmig ausgebildet, hoch aussteuerbar, rauscharm und liefert als kurzschlußfeste Wechselstromquelle einen maximalen Effektivstrom von mindestens 10 mA. Sie besteht im wesentlichen aus einem Impedanzwandler W1 der Spannungsverstärkung Eins mit einem nachgeschalteten Längswiderstand R und einem rückkoppelnden Impedanzwandler W2 (Figur 4).

EP 0 214 376 A2

FIG. 4

## Schaltungsanordnung für eine rauscharme Tonfrequenzquelle

Die Erfindung betrifft eine Schaltungsanordnung nach dem Oberbegriff des Patentanspruches 1.

Eine solche Schaltungsanordnung ist in der DE-PS 29 25 049 beschrieben. Sie ist insbesondere dann mit Vorteil anwendbar, wenn ein Mikrofon, beispielsweise ein Kondensatormikrofon oder dynamisches Mikrofon, bevorzugt mit nachgeschaltetem Übertrager, der die Mikrofonausgangsspannung noch etwas hinauftransformiert, an einen sogenannten Null-Ohm-oder Knotenpunkt-Verstärker angeschlossen werden soll; besonders nützlich ist die Erfindung dann, wenn es sich bei dem Null-Ohm-Verstärker um einen gesteuerten, insbesondere spannungsgesteuerten Verstärker handelt, also um einen sogenannten VCA (Voltage Controlled Amplifier).

Die DE-PS 29 25 049 bezieht sich auf einen solchen Fall, jedoch ist die hier vorliegende Erfindung auch bei anderen VCAs anwendbar, bei denen in der Regel -wie bei der Vorveröffentlichung -in der Eingangsstufe ein Operationsverstärker mit nichtlinearer Gegenkopplung vorgesehen ist.

In Figur 1 ist das Prinzip der vorveröffentlichten Anordnung dargestellt. An eine Tonfrequenzquelle T mit einem Mikrofon M und einem nachgeschalteten Übertrager Ü soll ein in seiner Verstärkung steuerbarer Null-Ohm-Verstärker N angeschlossen werden, der im wesentlichen aus einem Operationsverstärker OP mit einem steuerbaren (variablen) Gegenkopplungs-Widerstand V besteht. Der Null-Ohm-Verstärker hat einen sehr ge ringen Eingangswiderstand von annähernd 0 Ohm, der die Tonfrequenzquelle T zu stark belasten würde. Deshalb ist ein Impedanzwandler W zwischengeschaltet, dessen positiver Ausgangswiderstand wesentlich kleiner als sein Eingangswiderstand ist, und dessen Spannungsverstärkung so klein gewählt ist, daß sein Ausgangshubbereich bei seiner maximal vorkommenden Eingangsspannung nicht übersteuert ist. Zwischen dem Impedanzwandler W und dem Null-Ohm-Verstärker N befindet sich außerdem ein Längswiderstand L, dessen Widerstandswert relativ klein bemessen ist, damit er keinen wesentlichen Rauschbeitrag leistet. Der Längswiderstand L kann aber nicht ganz entfallen, weil sonst der Ausgang des Impedanzwandlers W durch den niedrigen Eingangswiderstand des Null-Ohm-Verstärker N zu stark belastet würde.

Der Längswiderstand ist außerdem für den Rauschbeitrag mitverantwortlich, den der Operationsverstärker OP selbst leistet: Diesen Rauschbeitrag kann man sich verursacht denken durch eine Rauschspannungsquelle unmittelbar am invertierenden Eingang des Operationsverstärkers OP. Die Rauschspannung der Rauschspannungsquelle wird von dem mit V und L beschalteten Operationsverstärker mit der sogenannten inneren Verstärkung des Null-Ohm-Verstärkers N verstärkt, die um so größer ist, je kleiner der Widerstandswert L ist.

Bei der in Figur 1 gezeigten Konfiguration leisten der Impedanzwandler W und der relativ kleine Längswiderstand L durch Erhöhung der inneren Verstärkung des Null-Ohm-Verstärkers N doch noch so hohe Rauschbeiträge, daß auch noch der Null-Ohm-Verstärker rauscharm dimensioniert werden müßte, wenn verschärften Forderungen nach einem noch rauscharmen Signal am Ausgang des Null-Ohm-Verstärkers entsprochen werden soll. Es hat sich aber als recht schwierig und aufwendig erwiesen, einen in seiner Verstärkung steuerbaren Null-Ohm-Verstärker entsprechend rauscharm zu dimensionieren.

Dementsprechend ist es Aufgabe der Erfindung, ein Schaltungskonzept anzugeben, das es zwar nicht erspart, fachmännische Maßnahmen zur rauscharmen Gestaltung von Schaltungsteilen zu ergreifen, das es aber ermöglicht, diese Maßnahmen weniger auf den Null-Ohm-Verstärker, sondern mehr auf andere Schaltungsteile zu konzentrieren, wo der für diese Maßnahmen erforderliche Aufwand erfahrungsgemäß geringer ist.

Diese Aufgabe wird gelöst durch die Schaltungsanordnung mit den Merkmalen des Patentanspruches 1. Vorteilhafte Weiterbildungen sind in den Unteransprüchen angegeben.

Der Erfindung liegen folgende Überlegungen zugrunde:

Auf der einen Seite sollte der Längswiderstand L in Figur 1 möglichst klein sein, damit er einen geringen Rauschbeitrag leistet. Andererseits sollte dieser Längswiderstand L aber auch einen möglichst großen Wert haben, um die innere Verstärkung klein zu halten und auch weil es aus einem weiteren Grund gut ist, dafür zu sorgen, daß das Verhältnis der Widerstandswerte V zu L nicht zu groß wird, denn bei einem zu großen Verhältnis dieser Werte, das an sich die Verstärkung des gegengekoppelten Null-Ohm-Verstärkers N bestimmt, wird die Gegenkopplung so schwach und die Verstärkung nähert sich so weit der Leerlaufverstärkung des Operationsverstärkers OP, daß sich die obere Grenzfrequenz dieser Leerlaufverstärkung störend bemerkbar macht.

Außerdem würde durch einen zu geringen Wert des Längswiderstandes L und infolge des geringen Eingangswiderstandes des Null-Ohm-Verstärkers N der Ausgang des Impedanzwandlers W weitgehend kurzgeschlossen, was bei einem üblichen Impedanzwandler zu dessen Funktionsstörung führen würde. Der Null-Ohm-Verstärker N würde kein Signal mehr erhalten, das ausreichend hoch über dem Rauschen liegt.

Durch die Erfindung werden diese Schwierigkeiten umgangen. Dabei wird ausgenutzt, daß sich die erfindungsgemäße Schaltungsanordnung erstens mit geringerem Aufwand rauscharm ausbilden läßt als beispielsweise ein steuerbarer Null-Ohm-Verstärker, daß sie sich zweitens relativ einfach so gestalten läßt, daß sie dem Null-Ohm-Verstärker bereits ein ausreichend weit über dem Rauschen liegendes, starkes Signal in Gestalt eines Stromes liefert, und daß sie drittens nicht merklich zur Erhöhung der inneren Verstärkung des Null-Ohm-Verstärkers beiträgt.

Anhand der restlichen Figuren wird die Erfindung näher erläutert.

Figur 2 zeigt ein Ersatzschaltbild der erfindungsgemäßen Schaltungsanordnung,

Figur 3 zeigt ein Blockschaltbild und

Figur 4 ein bevorzugtes Ausführungsbeispiel.

In Figur 2 ist der Impedanzwandler W und der Längswiderstand L aus Figur 1 ersetzt durch eine Schaltungsanordnung S mit einem Eingang E und einem Ausgang A. Es handelt sich um eine kurzschlußfeste Wechselstromquelle, d.h. um eine Quelle mit einem sehr hohen Innenwiderstand K, der von einer Ersatzspannungsquelle UE gespeist wird, die sehr hohe Spannungswerte liefert und der Spannung am Eingang E folgt. Durch diese Wechselstromquelle wird dem Null-Ohm-Verstärker N am Punkt A ein ausreichend hoch über dem Rauschen liegendes Signal in Gestalt eines Stromes zur Verfügung gestellt, so daß das Eigenrauschen des Null-Ohm-Verstärkers N weniger ins Gewicht fällt als bei der Anordnung nach Figur 1.

Man kann sich die Funktion der Schaltungsanordnung nach Fi gur 2 auch mit Hilfe der bekannten Gleichung für die Spannungsverstärkung eines gegengekoppelten Operationsverstärkers klarmachen, die sich aus dem Verhältnis von V zu K ergibt:

Dieser Quotient ist zwar infolge des hohen Innenwiderstandes K klein, es tritt also eine Spannungsabschwächung ein; die Ausgangsspannung des Null-Ohm-Verstärkers N wird aber immer noch größer als in Figur 1 sein, weil die Ersatzspannungsquelle UE eine sehr hohe Spannung abgibt.

Die Schaltungsanordnung S in Figur 2 ist rauscharm auszuführen, so daß der äquivalente Rauschwiderstand der Tonquelle T zusammen mit der nachgeschalteten Schaltungsanordnung S höchstens um 20%, bevorzugt höchstens um 10% höher als der äquivalente Rauschwiderstand der Tonquelle T allein liegt. Dies ist dadurch zu erreichen, daß der Innenwiderstand K, der ja ein Wechselspannungswiderstand ist, nur zu einem sehr kleinen Teil ohmscher Natur ist. Die Rauschwirkung dieses ohmschen Anteils kann man sich folgendermaßen vorstellen: Wenn die Ersatzspannungsquelle UE kurzgeschlossen wird und an die Stelle des ohmschen Anteils des Innenwiderstandes K eine Rauschspannungsquelle gesetzt wird, so ist ersichtlich, daß die davon erzeugte relativ kleine Rauschspannung lediglich mit dem sehr kleinen Verhältnis V zu K von dem Null-Ohm-Verstärker N verstärkt wird.

Wie der hohe Innenwiderstand K bei einem kleinen ohmschen Anteil und auch sonst nur geringen anderweitigen Rauschbeiträgen verwirklicht werden kann, wird weiter unten anhand der Figur 4 erläutert, zu der Figur 3 ein Blockschaltbild darstellt. Es zeigt, daß die Schaltungsanordnung S zwei Bestandteile enthält, nämlich ein Infraschallfilter F, auch Trittschallfilter genannt, und die eigentliche Wechselstromquelle U/I, welche die Spannung am Eingang E in einen Strom am Ausgang A wandelt. Der Null-Ohm-Verstärker N ist als VCA eingezeichnet, der durch eine Steuerspannung Us steuerbar ist.

In dem Ausführungsbeispiel nach Figur 4 ist eine bevorzugte Ausgestaltung der Schaltungsanordnung S angegeben. Die wesentlichen Bestandteile sind ein erster Impedanzwandler W1, der eingangsseitig hochohmig, d.h. um mehrere Zehnerpotenzen höherohmig als ausgangsseitig ist und eine Spannungsverstärkung von Eins aufweist. Dies wird durch starke Gegenkopplung über den negativen Eingang des im Impedanzwandler W1 enthaltenen Operationsverstärkers erreicht. Nachgeschaltet ist ein Längswiderstand R, an welchem die Spannung Ue abgebildet wird. In einem Rückkoppelweg RW ist ein zweiter Impedanzwandler W2 der gleichen Art wie W1 angeordnet, der für die exakte Abbildung der Spannung Ue am Längswiderstand R sorgt. Um dies zu verstehen, muß bedacht werden, daß der Ausgang A wegen des Null-Ohm-Einganges des VCA wechselspannungsmäßig praktisch auf Erdpotential liegt. Durch W2 wird auch die mit dem Rückkoppelweg RW verbundene Klemme des Übertrager Ü auf Erdpotential gehalten. Signale Ue, die vom Übertager Ü kommen, werden durch die Verstärkung von Eins des Impedanzwandlers W1 auf den Längswiderstand R abgebildet.

Ursache für die am Längswiderstand R abfallende, die Eingangsspannung abbildende Spannung Ue muß ein durch R fließender Strom sein. Da der Längswiderstand R zwischen dem niederohmigen Ausgang von W1 und dem hochohmigen Eingang von W2 liegt, kann der Strom nur über den Eingang A des Null-Ohm-Verstärkers N abfließen. Die Hochohmigkeit der durch S gebildeten Wechselstromquelle läßt sich durch die Überlegung verdeutlichen, daß eine wechselnde Potentialverschiebung bei A zwar auch das Potential an beiden Klemmen (über die Übertragerwicklung) des Einganges E verschieben würde, auf Ue und damit auf den Strom durch R aber ohne Einfluß bleibt.

Die gezeigte Schaltungsanordnung S bildet eine Kurzschlußfeste Wechselstromquelle, die mit einem Ausgangswechselstrom von maximal 50 mA effektiv dem VCA ein so starkes Signal liefert, daß an dessen Rauschfreiheit keine allzu großen Anforderungen gestellt werden müssen. Dazu trägt auch bei, daß die Schaltungsanordnung S selbst nur einen geringen Rauschbeitrag leistet.

Wird als Mikrofon M ein dynamisches Mikrofon mit einem Innenwiderstand von 200 Ohm und ein Übertrager mit einem Übersetzungsverhältnis von 1:2 gewählt, so beträgt die Quellimpedanz der Tonfrequenzquelle T 800 Ohm. Zu den damit geleisteten Rauschbeiträgen addiert sich der äquivalente Rauschwiderstand der Schaltungsanordnung S. In dieser liefern die Operationsverstärker Beiträge entsprechend jeweils einem äquivalenten Rauschwiderstand von ungefähr 40 Ohm. Hinzukommt noch die Wirkung des Längswiderstandes R, der Beispielsweise 100 Ohm aufweisen kann. Er sollte mit Rücksicht auf das Rauschen möglichst klein gewählt werden, darf aber auch nicht zu klein sein, damit kein zu großer Strom in den VCA fließt.

Die Spannungsverstärkung der Schaltungsanordnung S ist nahezu Null. Ihr innerer Signalhub entspricht der maximal vorkommenden Eingangsspannung. Dabei ist an einen Aussteuerungsbereich von 140 bis 150dB gedacht. Die Eingangsimpedanz der Schaltungsanordnung S ist mindestens zehnmal größer als die Quellimpedanz der Tonfrequenzquelle T, damit diese nicht zu stark belastet wird und nicht durch ein zu ungünstiges Spannungsteilerverhältnis das Signal-Rauschverhältnis merklich verschlechtert wird.

Das Übersetzungsverhältnis des Übertragers Ü ist bei einem dynamischen Mikrofon bevorzugt 1:2 (bis 1:3) und bei einem Kondensatormikrofon bevorzugt etwa 1:1. Ein größeres Übersetzungsverhältnis wäre an sich wünschenswert, jedoch wird es dann schwierig, die am Eingang E entstehenden großen Spannungen in der Schaltungsanordnung S verzerrungsfrei zu verarbeiten.

In der Schaltungsanordnung S ist noch ein Infraschallfilter enthalten. Es ist ein besonderer Vorzug der Erfindung und insbesondere des Ausführungsbeispiels nach Figur 4, daß dieses Infraschallfilter nicht wie bisher erst hinter dem VCA angeordnet sein kann, sondern sich schon vor dem positiven Eingang des Impedanzwandlers W1 befindet. Es besteht aus den beiden Widerstands-Kondensatorkombinationen R1-C1 und R2-C2. Während es bei der Anordnung des Trittschallfilters hinter dem VCA geschehen konnte, daß schon die Vorstufen durch Trittschall übersteuert wurden, ist dies bei der Anordnung nach Figur 4 vermieden, und zwar ohne daß das Rauschverhalten der Schaltungsanordnung S durch das integrierte Trittschallfilter wesentlich beeinträchtigt wird.

Eine weitere Kombination R3-C3 dient zur Verbesserung der Eigenschaften des Übertragers Ü.

Schließlich sind am Ausgang A abgesehen von Koppelkondensatoren C4, C5 noch Widerstände R4, R5 und ein Kondensator C6 vorgesehen. R5 und C6 dienen lediglich dazu, eine eventuelle Schwingneigung des VCA zu unterbinden. Die Kapazität von C6 ist sehr gering mit einem Wechselstromwiderstand, der im Nutzfrequenzbereich kleiner als R4 ist. Dieser Widerstand R4 hat einen Wert in der Größenordnung von 20 kOhm und ist damit so hochohmig bemessen, daß durch ihn die innere Verstärkung des Null-Ohm-Verstärkers N nicht merklich, d.h. vorzugsweise nicht um mehr als 10% erhöht wird.

**Ansprüche**

1. Schaltungsanordnung für Tonfrequenzen zum Zwischenschalten zwischen eine rauscharme Tonfrequenzquelle (T) und einen Verstärker, der als sogenannter Null-Ohm-Verstärker (N) ausgebildet und bevorzugt in seiner Verstärkung steuerbar (Us) ist, mit folgenden Merkmalen:

-sie ist eingangsseitig hochohmig, d.h. um mindestens eine Zehnerpotenz höherohmig als die Quellimpedanz der Tonfrequenzquelle (T),

-ihre Spannungsverstärkung ist so klein gewählt, daß ihr Ausgangssignalhubbereich bei der maximal vorkommenden Eingangsspannung nicht übersteuert ist,

gekennzeichnet durch folgende Merkmale:

-sie ist ausgangsseitig als kurzschlußfeste Wechselstromquelle ausgebildet, die einen maximalen Effektivstrom von mindestens 10mA liefert,

-der äquivalente Rauschwiderstand der Schaltungsanordnung (S) beträgt höchstens 20% des äquivalenten Rauschwiderstandes der Tonquelle - (T),

-ein gegebenenfalls am Ausgang (A) der Schaltungsanordnung (S) befindlicher Querzweig (R4) ist so hochohmig bemessen, daß die innere Verstärkung des nachfolgenden Null-Ohm-Verstärkers (N) nicht wesentlich erhöht wird und somit auch keine wesentliche Rauscherhöhung in diesem auftritt.

2. Schaltungsanordnung nach Anspruch 1, dadurch gekennzeichnet , daß der äquivalente Rauschwiderstand der Schaltungsanordnung (S) höchstens 10% des äquivalenten Rauschwiderstandes der Tonquelle (T) beträgt.

3. Schaltungsanordnung nach Anspruch 1 oder 2, dadurch gekennzeichnet, daß der Querzweig - (R4) so hochohmig bemessen ist, daß die innere Verstärkung des Null-Ohm-Verstärkers (N) um nicht mehr als 10% erhöht wird.

4. Schaltungsanordnung nach Anspruch 1, 2 oder 3, gekennzeichnet durch folgende Merkmale:

-sie enthält einen ersten Impedanzwandler (W1), der eingangsseitig hochohmig, d.h. um mehrere Zehnerpotenzen höherohmig als ausgangsseitig ist und dem ein Längswiderstand (R) nachgeschaltet ist,

-der erste Impedanzwandler (W1) mit dem Längswiderstand (R) ist durch einen Rückkoppelweg (RW) mit einem zweiten Impedanzwandler (W2), der eingangsseitig ebenfalls hochohmig ist, überbrückt, wobei die Schleifenverstärkung maximal Eins ist.

5. Schaltungsanordnung nach Anspruch 4, dadurch gekennzeichnet, daß beide Impedanzwandler (W1, W2) eine Spannungsverstärkung von angenähert Eins aufweisen.

6. Schaltungsanordnung nach einem der vorangehenden Ansprü che, dadurch gekennzeichnet, daß sie zugleich als aktives Infraschallfilter (F; R1-C1, R2-C2) ausgebildet ist.

FIG. 1

FIG. 2

FIG. 3

FIG. 4